# FASCICULE DE BREVET EUROPEEN

(11) **EP 0 798 953 B1**
(45) Date de publication et mention de la délivrance du brevet: **13.08.2003**
(21) Numéro de dépôt: 97410034.9
(22) Date de dépôt: 19.03.1997
(51) Int. Cl.: H05K 7/18, H02B 1/30

(54) **Armoire électrique extensible, et à socle intégré**
Ausbaubare Schaltschrank mit integriertem Sockel
Expandable electrical cabinet with integrated pedestal

(30) Priorité: 29.03.1996 FR 9604279
(43) Date de publication de la demande: 01.10.1997
(73) Titulaire: Schneider Electric Industries SAS, 92500 Rueil-Malmaison (FR)
(72) Inventeur: Bonnet, Jean-Marc, 38050 Grenoble Cedex 09 (FR); Potonniée, Jean-Christophe, 38050 Grenoble Cedex 09 (FR); Baveux, Antoine, 38050 Grenoble Cedex 09 (FR)
(74) Mandataire: Ritzenthaler, Jacques

(56) Documents cités:
- EP-A- 0 293 637
- FR-A- 2 300 442
- US-A- 4 369 484

## Description

L'invention est relative à une armoire pour appareillage électrique ayant un châssis comportant :
- un panneau de fond constitué par une plaque de tôle rectangulaire portant des éléments de support de l'appareillage,
- au moins quatre piliers, dont un premier et un deuxième piliers agencés à la partie supérieure et s'étendant perpendiculairement au panneau de fond, pour servir de support à l'habillage de l'armoire en forme de cadre, comprenant des flancs latéraux en forme de plaques à bords repliés, la longueur de chaque pilier correspondant sensiblement à la profondeur de l'armoire,
- des moyens de passage des câbles de raccordement de l'armoire,
- une porte et/ou un plastron destinés à être fixés sur la partie antérieure du cadre, après montage de l'appareillage et câblage du coffret,

Une armoire connue du genre mentionné est décrite en détail dans le document EP-A-143.718. Les flancs latéraux s'étendent jusqu'au bas de l'ossature, et les quatre piliers sont agencés aux quatre coins du panneau de fond. L'accès pour la fixation au sol d'une telle armoire est très réduit, et le raccordement des câbles par le bas reste malaisé selon l'environnement des sites d'installation.

L'objet de l'invention consiste à améliorer les conditions d'installation et de raccordement d'une armoire électrique extensible.

L'armoire selon l'invention est caractérisée en ce que les troisième et quatrième piliers agencés à la partie inférieure sont rapportés sur le panneau de fond à un niveau intermédiaire pour délimiter un socle intégré de manière rigide sur le châssis, et comprenant
- une paire de goussets latéraux équipés de moyens de fixation sur le panneau de fond et les troisième et quatrième piliers chaque gousset étant coplanaire avec le flanc latéral correspondant de l'habillage,
- et une plinthe fixée de manière amovible sur la partie frontale des goussets, l'arrière du socle étant obturé par le panneau de fond.

Selon une caractéristique de l'invention, le troisième ou quatrième pilier présente une structure double comportant un élément supérieur destiné à recevoir la base du flanc latéral et un élément inférieur pour la fixation du gousset correspondant.

Les bords opposés de la plinthe comportent des moyens de positionnement coopérant avec des éléments conjugués des goussets pour constituer un dispositif d'articulation autorisant un pivotement de la plinthe lors du montage ou du démontage du socle.

Selon un mode de réalisation préférentiel, le châssis est doté d'au moins un montant avant intermédiaire formé par un profilé en V ayant des arêtes inclinées prolongées par deux ailes conformées en équerre, et comprenant de plus :
- une première série d'ouvertures ménagées dans les arêtes pour la réception des charnières et des arrêts de pêne du système de fermeture équipant la porte,
- une deuxième série d'orifices prévus dans les ailes pour la fixation du plastron de l'appareillage,
- l'ensemble des ouvertures et orifices du profilé étant agencé symétriquement par rapport au plan médian vertical, et au plan médian horizontal du châssis pour permettre un montage latéral à droite ou à gauche de la gaine et/ou d'une armoire d'extension par rapport à l'armoire de base, et le choix du sens d'ouverture à droite ou à gauche de la porte.

Le nombre d'ouvertures de la première série est inférieur à celui des orifices de la deuxième série.

D'autres avantages et caractéristiques ressortiront plus clairement de la description qui va suivre d'un mode de réalisation de l'invention, donné à titre d'exemple non limitatif, et représenté aux dessins annexés, dans lesquels :
- la figure 1 est une vue éclatée en perspective du panneau de fond et des deux montants arrière,
- la figure 2 est identique à celle de la figure 1 en position assemblée des montants arrière sur le panneau de fond,
- la figure 3 est une vue éclatée en perspective du châssis de l'armoire de base,
- la figure 4 est une vue en perspective du châssis, après enlèvement de l'habillage latéral, supérieure et de la plinthe du socle,
- la figure 5 est une vue de détail à échelle agrandie de la figure 3, montrant le montage d'un gousset du socle,
- le figure 6 est une vue identique à la figure 4, après montage de la plinthe du socle,
- la figure 7 représente une vue en perspective du socle, lors de la mise en place de la plinthe,
- la figure 8 est une vue schématique en coupe transversale de l'armoire de base selon la figure 3,
- les figures 9 à 13 montrent différentes configurations d'association d'armoires et de gaines pour augmenter la capacité d'installation et de raccordement,
- la figure 14 est une vue en élévation du montant avant intermédiaire permettant les différentes configurations selon les figures 9 à 13,
- la figure 15 est une vue en coupe selon la ligne 15-15 de la figure 14,
- la figure 16 montre une vue éclatée en perspective de l'armoire selon la figure 9,
- la figure 17 montre l'armoire de la figure 16 dans l'état de montage final,
- la figure 18 représente l'assemblage de l'armoire selon la figure 11.

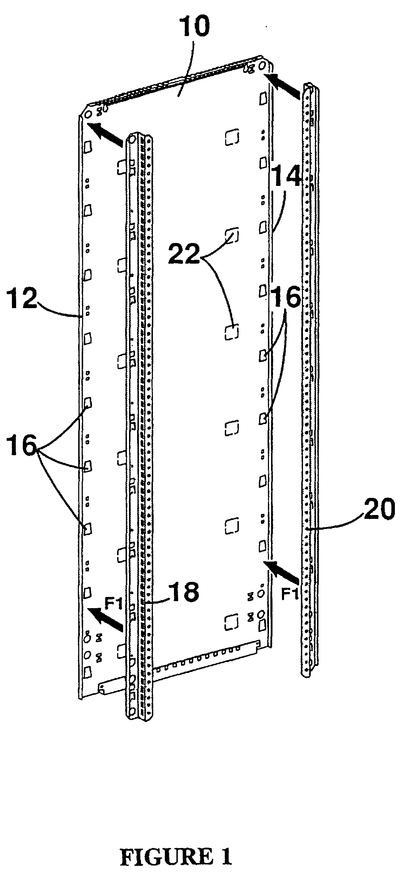

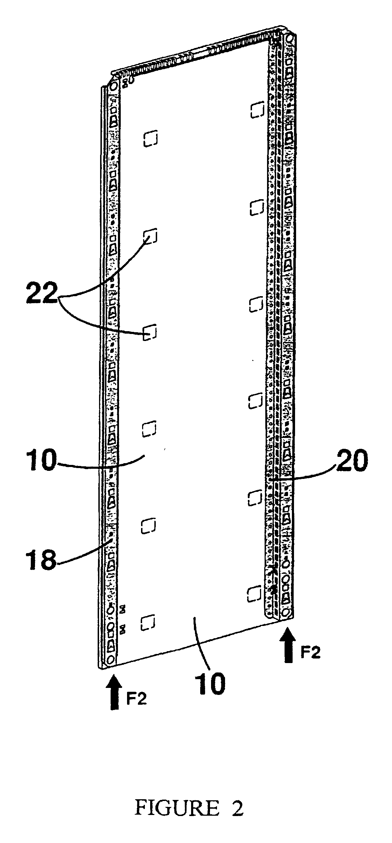

En référence aux figures 1 et 2, un panneau de fond 10 monobloc est constitué par une plaque de tôle rectangulaire percée le long de ses bords 12, 14 verticaux opposés par une pluralité d'orifices 16. Deux montants 18, 20 sont rapportés par encliquetage sur le panneau de fond 10 grâce à des éléments d'assemblage introduits dans les orifices 16 selon le sens des flèches F1 (figure 1) puis verrouillées par agrafage à la suite d'un mouvement de translation indiqué par les flèches F2 (figure 2).

Ce principe d'assemblage est décrit en détail dans le document EP-A-557 213. Le panneau de fond comporte d'autre part une série de préperçages 22 pour autoriser l'accès des câbles par l'arrière. Les montants 18, 20 peuvent recevoir une platine ou des rails de fixation d'appareils électriques.

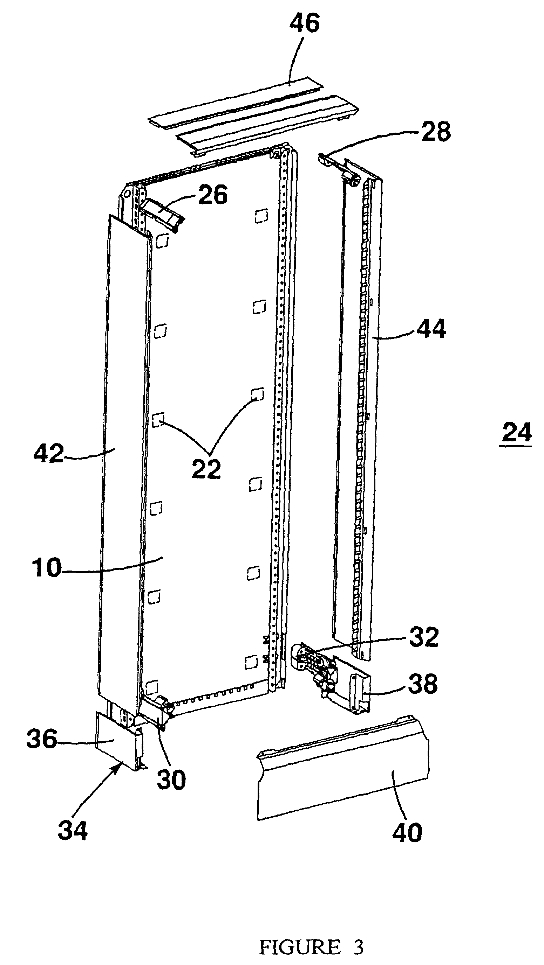

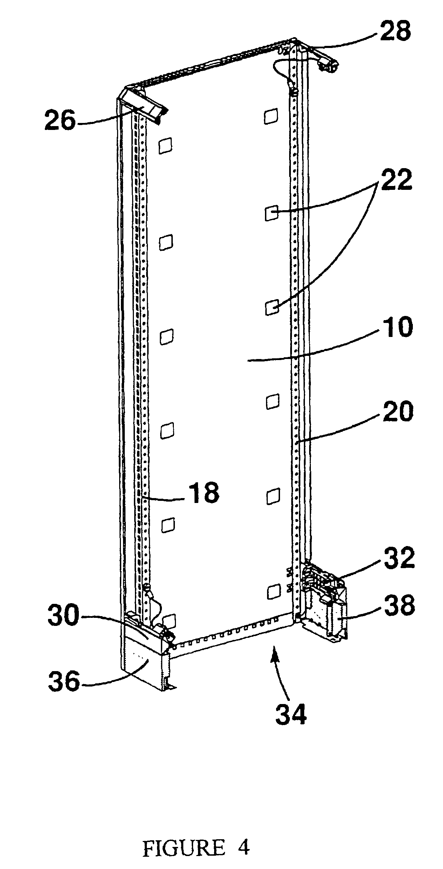

Les figures 3 et 4 montrent le châssis 24 de l'armoire électrique, formé par l'assemblage d'éléments amovibles facilitant le câblage et les interventions de maintenance. Un premier pilier 26 et un deuxième pilier 28 sont montés aux deux coins supérieurs du panneau de fond 10 ; dans la partie inférieure, un troisième et un quatrième piliers 30, 32 sont rapportés sur le panneau 10 à un niveau intermédiaire délimitant le socle 34.

Le socle 34 est intégré de manière rigide sur le châssis, et est formé par deux goussets 36, 38 latéraux comprenant des moyens de fixation rapide sur les montants 18, 20 du panneau de fond 10, et sur les troisième et quatrième piliers 30, 32.

L'arrière du socle 34 est obturé par le panneau de fond 10 avec prolongement des montants 18, 20 jusqu'à la base du châssis 24. A l'avant du socle 34 se trouve une plinthe 40 amovible, destinée à être rapportée sur la partie frontale des goussets 36, 38. Le démontage de la plinthe 40 et des goussets 36, 38 facilite le raccordement des câbles par le bas. Une plaque passe-câble (non représentée) également amovible, peut être agencée au niveau de l'interface entre le socle 34 et la zone supérieure de logement de l'appareillage.

Le reste de l'habillage de l'armoire comporte des flancs 42, 44 latéraux en tôle à bords pliés permettant un accès dans la zone de raccordement désirée, et une plaque supérieure 46 en deux parties pour l'entrée des câbles. Les différents piliers 26, 28, 30, 32 du châssis 24 présentent des faces visibles de l'extérieur au niveau des interfaces d'assemblage des différents éléments amovibles de l'habillage. L'intégration du socle 34 rigide au châssis 24 permet le transport et les manipulations de l'armoire.

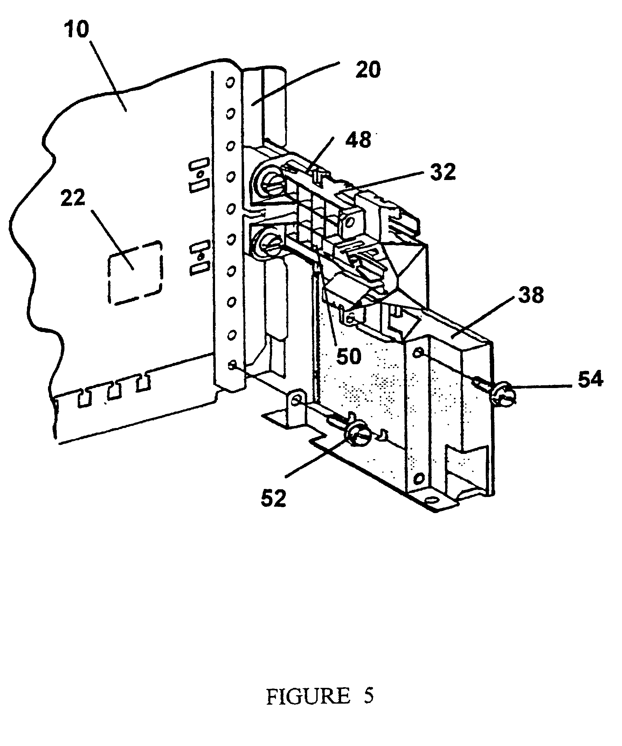

Sur la figure 5, le quatrième pilier 32 de droite présente une structure double identique à celle du troisième pilier 30 de gauche et comportant un élément supérieur 48 destiné à recevoir la base du flanc latéral 44, et un élément inférieur 50 pour la fixation du gousset 38. Une première vis 52 fixe la partie inférieure du gousset 38 au panneau de fond 10 après passage dans un orifice de montant 20. Une deuxième vis 54 raccorde la partie supérieure du gousset 38 à l'élément inférieur 50 du pilier 32.

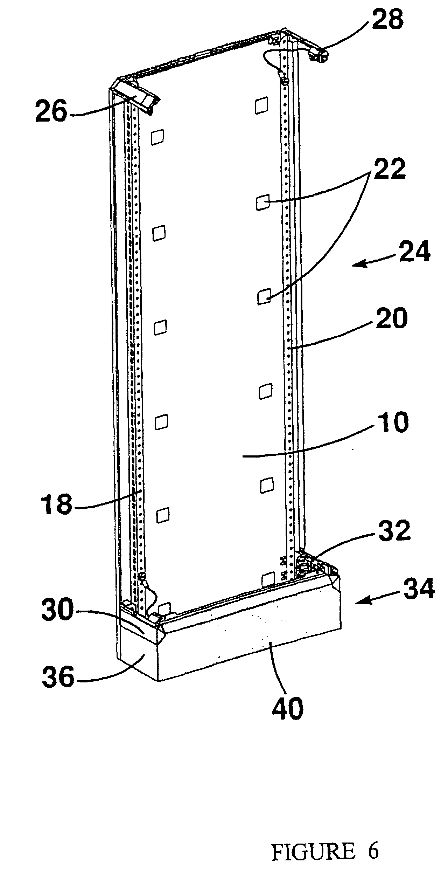

La figure 6 montre le montage final du socle 34 sur le châssis 24, l'ensemble étant monobloc et rigide.

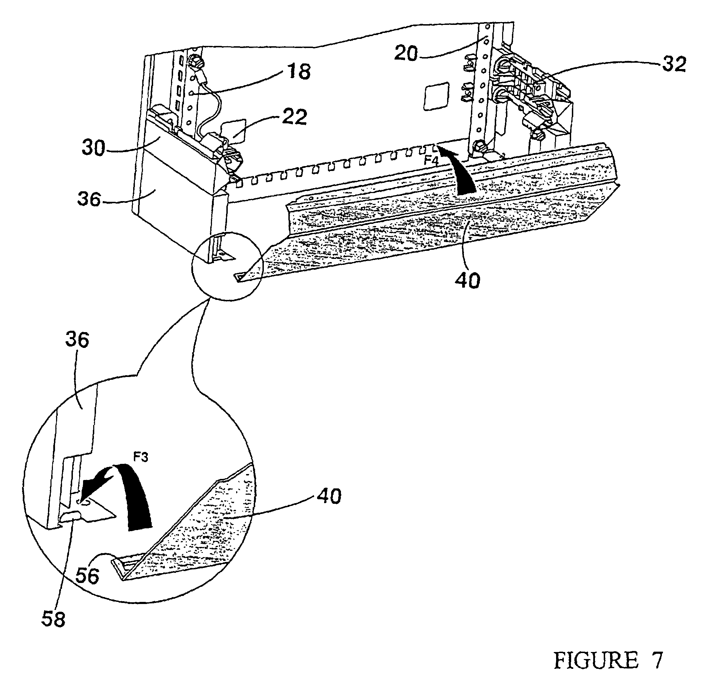

La figure 7 représente l'assemblage de la plinthe 40 sur le socle 34. Une fente de positionnement 56 ménagée dans un rebord plié de la plinthe 40 est d'abord engagée dans une protubérance 58 de chaque gousset 36, 38 (voir flèche F3) de manière à constituer un dispositif d'articulation. La plinthe 40 est ensuite déplacée par pivotement dans le sens de la flèche F4 pour obturer la face frontale du socle 34.

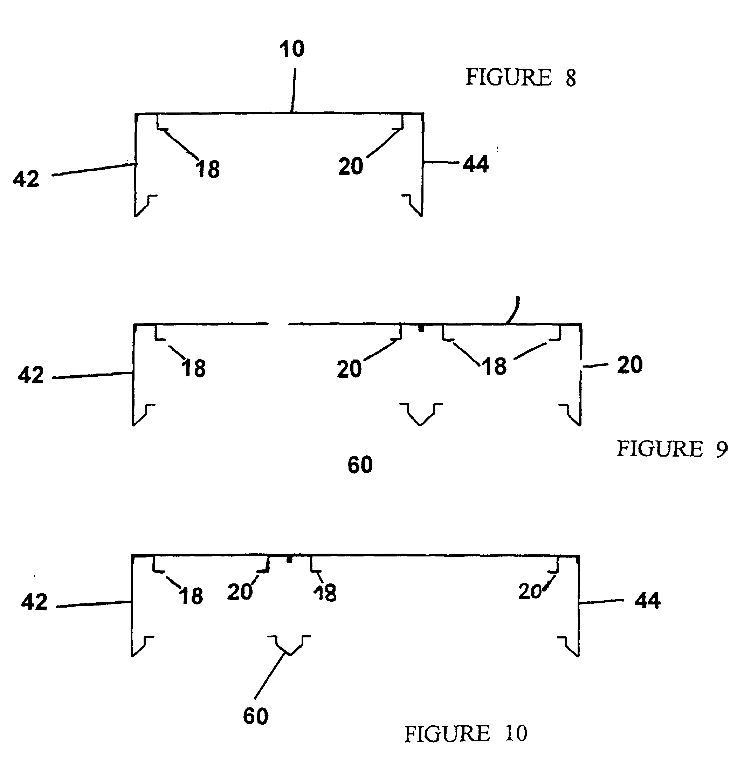

La figure 8 montre une vue schématique en coupe transversale de l'armoire A de base de la figure 3, après assemblage des éléments de l'habillage, sauf la porte. A partir de cette ossature, il est possible d'assurer une augmentation en capacité d'installation et de raccordement de l'armoire par adjonction de gaines ou d'armoires supplémentaires.

Les figures 9 et 10 illustrent l'association d'une gaine G d'extension à droite ou à gauche de l'armoire de base A. La gaine G est dotée d'un panneau de fond 100 sur lequel sont fixés deux montants 18, 20 identiques à ceux de l'armoire de base A. La largeur du panneau de fond 100 de la gaine G est inférieure à celle du panneau de fond 10 de l'armoire de base A.

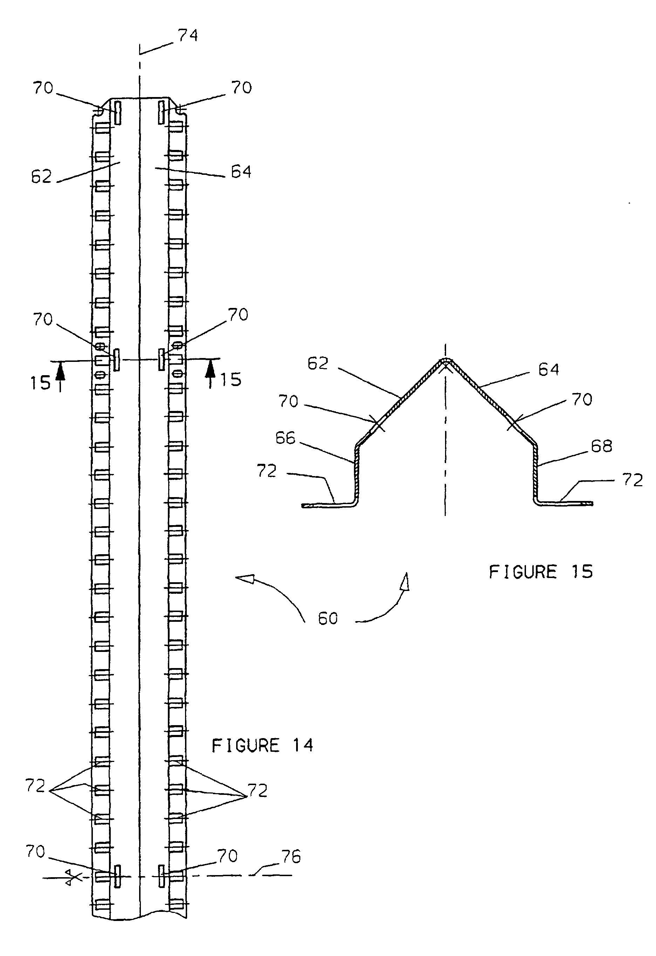

L'assemblage modulaire de l'armoire de base A et de la gaine G s'effectue au moyen d'un montant avant intermédiaire 60 ayant une structure monobloc symétrique illustrée en détail sur les figures 14 et 15. Le montant intermédiaire 60 comporte un profilé en V dont les arêtes 62, 64 inclinées sont prolongées par deux ailes 66, 68 en forme d'équerres. Les arêtes 62, 64 comportent chacune une série d'ouvertures 70 rectangulaires pour la réception des charnières et des arrêts de pênes du système de fermeture, tandis que les ailes 66, 68 sont percées par une pluralité d'orifices 72 pour la fixation du plastron de l'appareillage.

Les ouvertures 70 et orifices 72 du montant intermédiaire 60 sont agencés de manière symétrique par rapport au plan médian vertical 74, et au plan médian horizontal 76. Cette double symétrie permet un agencement à droite (figure 9) ou à gauche (figure 10) de la gaine G, ainsi que le choix d'ouverture à droite ou à gauche de la porte.

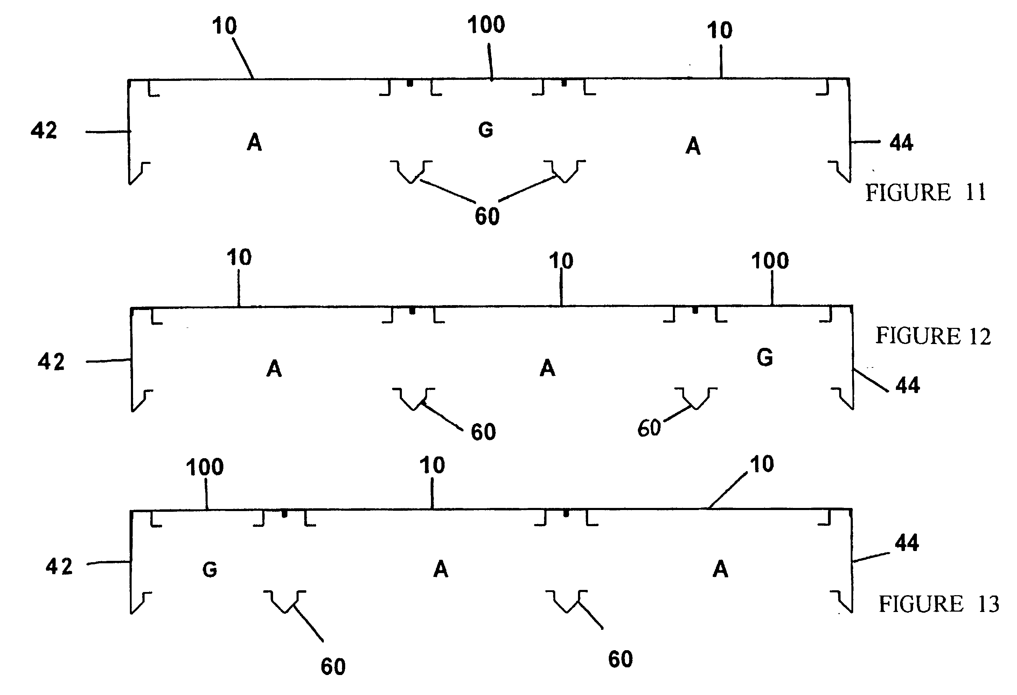

La figure 11 montre l'assemblage de la figure 9 avec adjonction à droite de la gaine G d'une deuxième armoire de base A. La gaine G se trouve ainsi insérée entre deux armoires de base A, par l'intermédiaire de deux montants intermédiaires 60.

La figure 12 représente l'association de deux armoires de base A adjacentes, et une gaine G à droite.

Dans la figure 13, la gaine G se trouve à gauche des deux armoires A. Il est clair que d'autres configurations d'association sont possibles pour augmenter en capacité d'installation d'appareillage et de raccordement, tout en utilisant les mêmes éléments standards de l'habillage et du châssis 24. Une telle extension peut être opérée avant ou après installation sur la site.

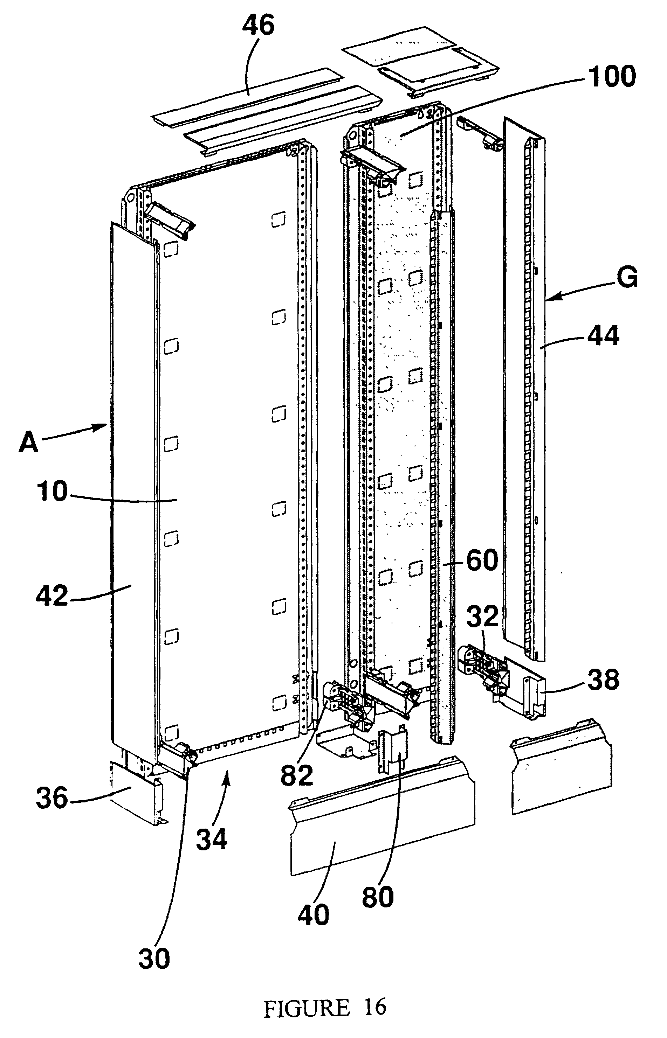

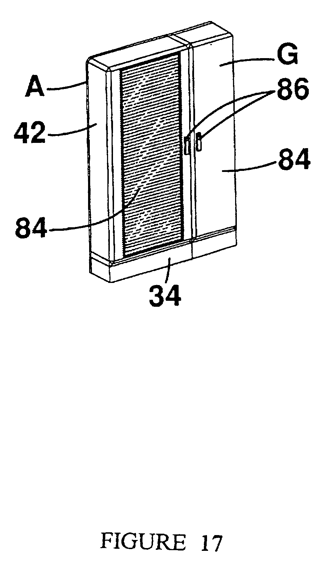

La figure 16 montre une vue éclatée en perspective de l'armoire selon la figure 9. Le gousset 38 de droite est reporté du côté de la gaine G, tandis que l'assemblage du socle 34 entre l'armoire de base A et la gaine G s'opère par l'intermédiaire d'un gousset 80 et d'un pilier 82 additionnels. La figure 17 montre l'armoire de la figure 16 en position de montage final.

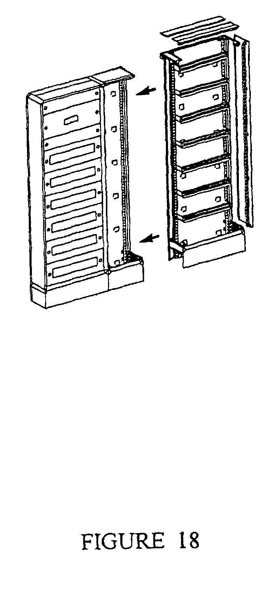

La figure 18 montre l'assemblage de l'armoire selon la figure 11.
Une porte 84 (figure 17) peut être adaptée à chaque armoire de base A et à chaque gaine G. La zone couverte par chaque porte présente un plan de symétrie verticale et horizontale. La porte peut être transparente ou pleine, et s'ouvrir vers la droite ou vers la gauche. L'organe de manoeuvre 86 de chaque porte 84 se trouve disposé dans le plan horizontal médian.

## Revendications

1. Armoire pour appareillage électrique ayant un châssis (24) comportant :
- un panneau de fond (10) constitué par une plaque de tôle rectangulaire portant des éléments de support de l'appareillage,
- au moins quatre piliers (26, 28, 30, 32), dont un premier et un deuxième piliers 26, 28 agencés à la partie supérieure et s'étendant perpendiculairement au panneau de fond (10), pour servir de support à l'habillage de l'armoire en forme de cadre, comprenant des flancs (42, 44) latéraux en forme de plaques à bords repliés, la longueur de chaque pilier correspondant sensiblement à la profondeur de l'armoire,
- des moyens de passage (46) des câbles de raccordement de l'armoire,
- une porte (84) et/ou un plastron destinés à être fixés sur la partie antérieure du cadre, après montage de l'appareillage et câblage du coffret,
**caractérisée en ce que**
les troisième et quatrième piliers 30, 32 agencés à la partie inférieure sont rapportés sur le panneau de fond (10) à un niveau intermédiaire pour délimiter un socle (34) intégré de manière rigide sur le châssis (24), et comprenant :
- une paire de goussets (36, 38) latéraux équipés de moyens de fixation sur le panneau de fond (10) et les troisième et quatrième piliers (30, 32), chaque gousset étant coplanaire avec le flanc latéral correspondant de l'habillage,
- et une plinthe (40) fixée de manière amovible sur la partie frontale des goussets (36, 38), l'arrière du socle étant obturé par le panneau de fond (10).

2. Armoire pour appareillage électrique selon la revendication 1, **caractérisée en ce que** le troisième ou quatrième pilier (30, 32) présente une structure double comportant un élément supérieur (48) destiné à recevoir la base du flanc latéral 42, 44, et un élément inférieur (50) pour la fixation du gousset (36, 38) correspondant.

3. Armoire pour appareillage électrique selon la revendication 2, **caractérisée en ce que** les bords opposés de la plinthe (40) comportent des moyens de positionnement coopérant avec des éléments conjugués des goussets (36, 38) pour constituer un dispositif d'articulation autorisant un pivotement de la plinthe (40) lors du montage ou du démontage du socle (34).

4. Armoire pour appareillage électrique selon l'une des revendications 1 à 3, et susceptible d'être accolée à une gaine (G) et/ou à une armoire ou coffret pour une extension modulaire de la capacité d'installation et de raccordement supplémentaires,
**caractérisée en ce que** le châssis (24) est doté d'au moins un montant avant intermédiaire (60) formé par un profilé en V ayant des arêtes (62, 64) inclinées prolongées par deux ailes (66, 68) conformées en équerre, et comprenant de plus :
- une première série d'ouvertures (70) ménagées dans les arêtes (62, 64) pour la réception des charnières et des arrêts de pêne du système de fermeture équipant la porte,
- une deuxième série d'orifices (72) prévus dans les ailes (66, 68) pour la fixation du plastron de l'appareillage,
- l'ensemble des ouvertures (70) et orifices (72) du profilé étant agencé symétriquement par rapport au plan médian vertical (74), et au plan médian horizontal (76) du châssis 24 pour permettre un montage latéral à droite ou à gauche de la gaine (G) par rapport à l'armoire de base (A), et le choix du sens d'ouverture à droite ou à gauche de la porte (84).

5. Armoire pour appareillage électrique selon la revendication 4, **caractérisée en ce que** le nombre d'ouvertures (70) de la première série est inférieur à celui des orifices (72) de la deuxième série.

6. Armoire pour appareillage électrique selon l'une des revendications 1 à 5, **caractérisée en ce que** chaque porte (84) comporte un organe de manoeuvre disposé dans le plan horizontal médian (76).

## Patentansprüche

1. Schrank für elektrische Geräte mit einem Rahmengestell (24), das:
- eine Rückwand (10) in Form eines Rechteckblechs mit Tragmitteln für die elektrischen Geräte,
- mindestens vier Eckverbinder (26, 28, 30, 32), von denen ein erster und ein zweiter Eckverbinder 26, 28 an der Oberseite angeordnet sind und senkrecht zur Rückwand (10) verlaufen, welche Eckverbinder als Stützen für die rahmenförmige Verkleidung des Schranks dienen, die zwei plattenförmige Seitenwände (42, 44) mit umbogenen Kanten umfaßt, wobei die Länge jedes Eckverbinders annähernd der Tiefe des Schranks entspricht,
- Mittel (46) zur Durchführung der Anschlußkabel des Schranks,
- sowie eine Tür (84) und/oder eine Frontplatte umfaßt, die dazu dient, nach dem Anbringen der Verkleidung und der Verkabelung der Gehäuseeinheit auf der Vorderseite des Rahmens befestigt zu werden,
**dadurch gekennzeichnet, daß**
der dritte und der vierte Eckverbinder 30, 32 an der Unterseite in einer Zwischenhöhe auf der Rückwand (10) montiert sind, um einen biegesteif in das Rahmengestell (24) integrierten Sockel (34) zu begrenzen, der
- zwei seitliche Versteifungsbleche (36, 38) mit Mitteln zur Befestigung an der Rückwand (10) sowie am dritten bzw. vierten Eckverbinder (30, 32), welche Versteifungsbleche mit der jeweils zugeordneten Seitenwand der Verkleidung fluchten,
- sowie eine abnehmbar an der Vorderseite der Versteifungsbleche (36, 38) befestigte Blende (40) umfaßt, wobei die Rückseite des Sockels durch die Rückwand (10) verschlossen ist.

2. Schrank für elektrische Geräte nach Anspruch 1, **dadurch gekennzeichnet, daß** der dritte bzw. vierte Eckverbinder (30, 32) zweiteilig aufgebaut sind und ein Oberteil (48) zur Aufnahme der Unterseite der Seitenwand 42, 44 sowie ein Unterteil (50) zur Befestigung des jeweiligen Versteifungsblechs (36, 38) umfassen.

3. Schrank für elektrische Geräte nach Anspruch 2, **dadurch gekennzeichnet, daß** an den einander gegenüberliegenden Rändern der Blende (40) Positioniermittel ausgebildet sind, die mit zugeordneten Teilen der Versteifungsbleche (36, 38) zusammenwirken, um eine Gelenkanordnung zu bilden, die ein Verschwenken der Blende (40) bei der Montage bzw. Demontage des Sockels (34) erlaubt.

4. Schrank für elektrische Geräte nach einem der Ansprüche 1 bis 3, der an einen Kabelraum (G) und/oder einen Schrank oder ein Gehäuse zur modularen Erweiterung mit zusätzlicher Installations- und Anschlußkapazität angebaut werden kann,
**dadurch gekennzeichnet, daß** das Rahmengestell (24) mindestens einen vorderen Zwischenholm (60) umfaßt, der als V-Profil mit schräg verlaufenden Schenkeln (62, 64) ausgebildet ist, an die sich zwei Winkelschienen (66, 68) anschließen, und der außerdem
- eine erste Reihe von in den Schenkeln (62, 64) ausgebildeten Öffnungen (70) zur Aufnahme der Scharniere und Schloßplatten des Schließsystems der Tür,
- sowie eine zweite Reihe von in den Winkelschienen (66, 68) ausgebildeten Löchern (72) zur Befestigung der Frontplatte der Geräte umfaßt, wobei
- die in dem Profil ausgebildeten Öffnungen (70) und Löcher (72) in bezug zur senkrechten Mittelebene (74) sowie zur waagerechten Mittelebene (76) des Rahmengestells (24) symmetrisch angeordnet sind, um eine seitliche Montage des Kabelraums (G) links oder rechts vom Grundschrank (A) sowie einen links- oder rechtsseitigen Anschlag der Tür (84) zu erlauben.

5. Schrank für elektrische Geräte nach Anspruch 4, **dadurch gekennzeichnet, daß** die Anzahl der Öffnungen (70) der ersten Reihe kleiner ist als die Anzahl der Löcher (72) der zweiten Reihe.

6. Schrank für elektrische Geräte nach einem der Ansprüche 1 bis 5, **dadurch gekennzeichnet, daß** jede Tür (84) einen in der horizontalen Mittelebene (76) angeordneten Betätigungsgriff aufweist.

## Claims

1. A cabinet for electrical switchgear having a frame (24) comprising:
- a back panel (10) formed by a rectangular sheet metal plate supporting elements for support of the switchgear,
- at least four pillars (26, 28, 30, 32), a first and a second pillars (26, 28) of which being arranged at the top part and extending perpendicularly to the back panel (10) to act as support for the covering panels of the cabinet in the form of a frame, comprising side panels (42, 44) in the form of plates with folded edges, the length of each pillar corresponding appreciably to the depth of the cabinet,
- means (46) for running the connection cables of the cabinet,
- a door (84) and/or a front plate designed to be fixed onto the front part of the frame after the switchgear has been fitted and wiring of the cabinet has been performed,
**characterized in that**
the third and fourth pillars (30, 32) arranged at the bottom part are fitted onto the back panel (10) at an intermediate level to define a base (34) integrated in rigid manner on the frame (24) and comprising:
- a pair of lateral gussets (36, 38) equipped with means for fixing onto the back panel (10) and the third and fourth pillars (30, 32), each gusset being coplanar with the corresponding side panel of the covering,
- and a plinth (40) fixed in removable manner onto the front part of the gussets (36, 38), the rear of the base being blanked off by the back panel (10).

2. The electrical switchgear cabinet according to claim 1, **characterized in that** the third or fourth pillar (30, 32) presents a double structure comprising a top element (48) designed to receive the base of the side panel (42, 44) and a bottom element (50) for fixing of the corresponding gusset (36, 38).

3. The electrical switchgear cabinet according to claim 2, **characterized in that** the opposite edges of the plinth (40) comprise positioning means cooperating with conjugate elements of the gussets (36, 38) to form an articulation device allowing pivoting of the plinth (40) to take place when the base (34) is assembled or disassembled.

4. The electrical switchgear cabinet according to one of the claims 1 to 3, and able to be adjoined to a housing (G) and/or to a cabinet or enclosure for modular extension of the additional installation and connection capacity,
**characterized in that** the frame (24) is provided with at least one intermediate front crossmember (60) formed by a V-shaped profiled section having inclined edges (62, 64) extended by two wings (66, 68) shaped as brackets, and comprising in addition:
- a first series of openings (70) arranged in the edges (62, 64) to receive the hinges and bolt stops of the closing system equipping the door,
- a second series of holes (72) provided in the wings (66, 68) for fixing of the front cover plate of the switchgear,
- the set of openings (70) and holes (72) of the profiled section being arranged symmetrically with respect to the vertical mid-plane (74) and to the horizontal mid-plane (76) of the frame (24) to enable lateral assembly of the extension housing (G) to the right or to the left with respect to the basic cabinet (A), and giving the choice of opening of the door (84) to the left or to the right.

5. The electrical switchgear cabinet according to claim 4, **characterized in that** the number of openings (70) of the first series is smaller than that of the holes (72) of the second series.

6. An electrical switchgear cabinet according to one of the claims 1 to 5, **characterized in that** each door (84) comprises an operating part located in the horizontal mid-plane (76).
